# EUROPÄISCHE PATENTANMELDUNG

(11) **EP 2 648 223 A2**
(43) Veröffentlichungstag der Anmeldung: **09.10.2013**
(21) Anmeldenummer: 13162280.5
(22) Anmeldetag: 04.04.2013
(51) Int. Cl.: H01L 31/0224

(54) **Solarzelle und Verfahren zum Herstellen eines elektrischen Kontaktes auf einer solchen**

(30) Priorität: 04.04.2012 DE 102012205498
(71) Anmelder: Fraunhofer Gesellschaft zur Förderung der angewandten Forschung e.V., 80686 München (DE)
(72) Erfinder: Huber, Stephan, 83562 Rechtmehring (DE); Von Campe, Hilmar, 61352 Bad Homburg (DE)

(57) **Zusammenfassung**

Die Erfindung betrifft ein Verfahren zum Herstellen eines elektrischen Kontaktes auf der Emitterseite einer Solarzelle (Frontkontakt), bei dem eine elektrisch leitende bleihaltige Paste (3) auf der Solarzellenoberfläche aufgebracht wird und, zumindest teilweise überlappend, über die bleihaltige Paste (3) eine elektrisch leitende bleifreie Paste oder Leiterbahn (4) aufgebracht wird. Die Erfindung betrifft weiterhin eine Solarzelle mit einen Frontkontakt bildenden Leiterbahnen, hergestellt nach einem solchen Verfahren, wobei der Bleigehalt in der Leiterbahn höchstens 0,1 Gew.-%, bevorzugt unter 0,08 Gew.-% beträft

## Beschreibung

Die Erfindung betrifft ein Verfahren zum Herstellen eines elektrischen Kontaktes auf der Emitterseite einer Solarzelle, auch Frontkontakt genannt. Die Erfindung betrifft des Weiteren eine Solarzelle mit einen Frontkontakt bildenden Leiterbahnen.

Eine Solarzelle der hier beschriebenen Art ist im Wesentlich aufgebaut aus einem Halbleitersubstrat, insbesondere einem Silicium-Wafer, welcher dergestalt dotiert ist, dass er auf seiner Lichteinfallsseite (auch Emitterseite) wahlweise eine n-leitende Schicht und darunter eine p-leitende Schicht (auch Basis) oder umgekehrt als Emitter eine p-leitende Schicht und darunter eine n-leitende Basis aufweist. Auf der Emitterseite ist üblicherweise eine Antireflektionsschicht, z.B. eine Siliciumnitridschicht (nachfolgend auch kurz "Nitridschicht"), zur Erhöhung des Wirkungsgrades aufgebracht. Das auf die Emitterseite der Solarzelle auftreffende Licht wird unter Bildung freier Ladungsträger absorbiert. Die freien Ladungsträger (Elektronen und Löcher) werden in der Raumladungszone zwischen n-Seite und n-Seite getrennt. Die getrennten Ladungen werden über elektrische Kontakte auf der Ober - und Unterseite der Solarzelle abtransportiert und so Strom erzeugt.

Während üblicherweise die Basis vollflächig mit einem Leitermaterial, z. B. Aluminium, beschichtet ist, besteht der elektrische Kontakt auf der Emitterseite typischerweise aus einem aufgedruckten Muster aus einer elektrisch leitenden Paste. Meist wird der Emitter über schmale sogenannte Gridfinger kontaktiert, die untereinander durch einen oder mehrere sogenannte Busbars verbunden sind. Gridfinger und Busbar werden, soweit sie beide auf der Emitterseite angeordnet sind, hierin unter dem Oberbegriff Leiterbahn zusammengefasst. Sie bilden zusammen das sogenannte Frontgitter. Das Aufbringen der Leiterbahnen erfolgt üblicherweise mittels Siebdruckverfahren oder, wie zum Beispiel beim Fingerschreiben, mittels eines Dispensers, nachfolgend Dispenserverfahren genannt.

Die unmittelbar auf der Emitterseite der Solarzelle aufgebrachte elektrisch leitende Paste ist eine metallhaltige, meist eine Silber-basierte Leitpaste mit einem Bleianteil. Nach dem Trocknen der aufgebrachten Paste wird diese in einem Sinterprozess eingebrannt. Dies geschieht bei üblicherweise etwa 800° C, wobei verschiedene chemische Reaktionen zwischen der Leitpaste und der Fotozellenoberfläche ablaufen. Zunächst reagiert das Bleioxid in der Leitpaste mit der Antireflexschicht und öffnet diese, indem sich das Material der Antireflexschicht im Bleioxid auflöst. Während des Sinterns wird vermutlich das Bleioxid zu Blei reduziert, welches in Form von kleinen Schmelztröpfchen abgeschieden wird. Die Bleitröpfchen lösen einerseits das Metall aus der Leitpaste und andererseits das Silicium aus der Waferoberfläche an, wodurch sie mit Metall und Silicium angereichert werden. Beim Abkühlen der Solarzelle nach dem Sintern werden Metall-Keime aus der Blei-Lösung unmittelbar auf der Silicium-Waveroberfläche epitaktisch abgeschieden, wodurch sie den elektrischen Kontakt der gesinterten Metall-Leitpaste zur Emitterschicht herstellen.

Aus diesem Grund sind signifikante Blei-Anteile bei dieser Art der emitterseitigen Kontakte unverzichtbar.

Andererseits gibt es aus Umweltschutzgründen weltweit das Bestreben, Blei-Zusätze in möglichst allen technischen Anwendungen zu vermeiden. Um diesem Bestreben gerecht zu werden und teilweise bereits bestehenden gesetzlichen Bestimmungen auch in der Herstellung von Solarzellen nachzukommen, sehen sich die Entwickler mit der Frage konfrontiert, wie ein guter elektrischer Kontakt auf der Emitterseite ein Solarzellenprozess sicher und zugleich unter Einhaltung von angestrebten Umweltstandards hergestellt werden kann. Ein Ansatz wird in der Schrift WO 2006/132766A2 beschrieben. Es wird darin eine blei- und cadmium-freie Leitpaste für die Kontaktierung von Solarzellen vorgestellt, welche zu einem Teil aus Metall, bevorzugt Silber oder Aluminium, und zu einem Teil aus organischem Material mit 1-15 Gewichts-% einer bleifreien Glaskomponente besteht. Insbesondere durch Einstellung des Bismut- und Silicium-Anteils in Verbindung mit der Sintertemperatur soll eine variable Anpassung der Leitpaste an die Chemie der Solarzellenvorderseite bzw. -rückseite erzielbar sein.

Die vorliegende Erfindung hat zur Aufgabe, eine alternative Lösung des vorstehenden Problems anzubieten, welche prozesstechnisch gewohnt einfach und daher sicher umzusetzen ist.

Die Aufgabe wird gelöst durch ein Verfahren mit den Merkmalen des Anspruches 1 und durch eine Solarzelle mit den Merkmalen des Anspruches 21. Vorteilhafte Weiterbildung der Erfindung ist in den Unteransprüchen angegeben.

Das erfindungsgemäße Verfahren zum Herstellen eines elektrischen Kontaktes auf der Emitterseite einer Solarzelle sieht vor, eine elektrisch leitende bleihaltige Paste auf der emitterseitigen Solarzellenoberfläche aufzubringen und darüber, zumindest teilweise überlappend, eine elektrisch leitende bleifreie Leiterschicht aufzubringen.

Erfindungsgemäß ist es also beabsichtigt, den Einsatz bleihaltiger Pasten nur dort vorzunehmen, wo sie prozesstechnisch zur Sicherstellung eines guten Kontakts notwendig ist, d. h. unmittelbar auf der zu kontaktierenden Oberfläche der Solarzellenemitterseite. Die Erfinder haben erkannt, dass bereits eine sehr dünne Schicht der elektrisch leitenden bleihaltigen Paste genügt, um die eingangs beschriebenen chemischen Prozesse in Gang zu setzen und somit den Kontakt sicherzustellen. Der für die Ableitung des elektrischen Stromes benötigte Leiterquerschnitt des Gridfingers bzw. des gesamten Frontgitters wird durch den volumenmäßig größeren Anteil der darüber aufgetragenen bleifreien Leiterschicht bereitgestellt.

Neben dem Umweltaspekt birgt die Erfindung aber noch einen weiteren, überraschenden Vorteil. Aufgrund des reduzierten Anteils der bleihaltigen Paste in den Leiterbahnen des Frontkontaktes, der vorteilhafter Weise auch mit einer reduzierten, von der bleihaltigen Paste benetzten Oberfläche der Solarzelle einhergeht, wird die Nitridschicht entsprechend weniger beschädigt. Die darunterliegende Halbleiterschicht ist daher besser passiviert, was schließlich sogar den Wirkungsgrad der Solarzelle erhöht.

"Zumindest teilweise überlappend" heißt, dass die Schichten zum Zweck der Stromleitung zumindest in einem Bereich ummittelbar kontaktiert sein müssen. Eine vollständige Bedeckung der Schicht der bleihaltigen Paste mit der Schicht der bleifreien Paste ist zwar vorteilhaft aber hierzu nicht zwingend erforderlich.

Besonders bevorzugt wird auch die bleifreie Leiterschicht in Form einer bleifreien Paste aufgebracht.

Die eingesetzten Pasten sind jeweils Leitpasten mit einem organischen Anteil (Harz) und Feststoffen, die ein Metall, vorzugsweise Silber, und Glasfritten enthalten, welche ihrerseits Bestandteile wie beispielsweise Zinkoxid und nur im Fall der bleihaltigen Paste 1 bis 15 Gew.-%, bezogen auf den Feststoffanteil, Blei in Form von Bleioxid und im Übrigen Siliziumdioxid aufweisen.

Die bleihaltige Paste und /oder die bleifreie Paste werden nach ihrem Aufbringen jeweils vorzugsweise getrocknet, wobei das Aufbringen der bleifreien Paste über der bleihaltigen Paste vorzugsweise nach dem Trocknen der bleihaltigen Paste erfolgt.

Die Solarzelle wird nach einem weiteren Aspekt der Erfindung mit den aufgebrachten und gegebenenfalls getrockneten Pasten einer Wärmebehandlung unterzogen, wobei die Pasten unter Ausbildung von einer eine Kontaktschicht und eine Leiterschicht enthaltenden Leiterbahn, also der Gridfinger bzw. des gesamten Frontgitters, auf der Emitterseite gesintert werden.

Beim Sintern der erfindungsgemäß aufgetragenen Pasten laufen folgende Prozesse ab. Zu Beginn des Sinterprozesses schmilzt die bleihaltige Glasfritte und zieht sich dabei zusammen. Durch die Oberflächenspannung werden auch die Metallpartikel zusammengezogen. Der Sintervorgang löst so die Ausbildung eines monolitischen Körpers aus. Bei der bleifreien Paste wird der Sintervorgang analog nach dem Aufschmelzen der dort eingebrachten bleifreien Glasfritte in Gang gesetzt. Im Sinterprozess entsteht aus dem Pastenverbund der Gridfinger bzw. das Frontgitter in Form eines monolithischen Festkörpers mit leitenden Metallbestandteilen. Allerdings ist der Bleigehalt auch in dem gesinterten Gridfinger/Frontgitter keineswegs homogen. In unmittelbarem Kontakt zur Solarzellenoberfläche bildet sich eine bleihaltige Kontaktschicht aus, die die elektrische Verbindung des Gridfingers/Frontgitters zur Emitterseite herstellt. Der Gridfinger/das Frontgitter wird im Übrigen aus der gesinterten bleifreien Paste gebildet, nachfolgend als Leiterschicht bezeichnet. Kontaktschicht und Leiterschicht bilden zusammen die Leiterbahnen, also die Gridfinger bzw. das Frontgitter.

Alternativ wird die Solarzelle zunächst allein mit der aufgebrachten und gegebenenfalls getrockneten bleihaltigen Paste einer Wärmebehandlung unterzogen, wobei die Paste unter Ausbildung einer Kontaktschicht auf der Emitterseite gesintert wird und anschließend die elektrisch leitende bleifreie Leiterschicht durch galvanische Abscheidung aufgebracht wird.

Besonders bevorzugt ist das Verhältnis der aufgetragenen bleihaltigen Paste zu der bleifreien Leiterschicht unter Berücksichtigung des Bleigehalts in der bleihaltigen Paste so gewählt, dass der Bleigehalt gemittelt über die gesamten Leiterbahnen, also Gridfinger bzw. Frontgitter, höchstens 0,1 Gew. -%, bevorzugt 0,08 Gew. -% beträgt, wobei der Pb-Gehalt in der Kontaktschicht 1 - 20 Gew.-% und vorzugsweise 5-10 Gew.-% betragen kann.

Auf diese Weise wird sichergestellt, dass der Bleioxid-Zusatz in der fertig gesinterten Kontaktschicht einerseits eine sichere Kontaktierung gewährleistet und andererseits gesetzliche Anforderungen in Bezug auf eine Reduzierung des Bleianteils dennoch erfüllt werden. Bislang üblicherweise verwendete bleihaltige Kontakte weisen nach dem Sintern einen Blei-Gehalt von 1 bis 15 Gew.-% auf. Durch das erfindungsgemäße Verfahren findet also ein "Verdünnung" um einen Faktor von wenigstens 10 bis zu 300 statt. Das Verhältnis des Gewichts der aufgetragenen Pasten wird überwiegend über die Verhältnisse der Schichtdicken und der lateralen Abmessungen der beiden aufgebrachten Pasten eingestellt.

Vorzugsweise wird eine bleihaltige Paste verwendet, die einen Bleigehalt von 1 bis 20 Gew.-%, vorzugsweise von 5 bis 10 Gew. -% aufweist.

Bevorzugt werden die bleihaltige Paste oder beide Pasten mittels Siebdruck, Tintenstrahldruck oder mittels Dispenservedahren aufgebracht.

Die elektrisch leitenden Pasten weisen Metallbestandteile in Partikelform, bevorzugt in Form von Kupfer- oder Aluminum- und besonders bevorzugt in Form von Silber-Partikeln auf. Hierbei ist darauf zu achten, dass die Partikelgröße geringer als die Schichtdicke ist.

Die Metall-Partikel können sowohl in der bleihaltigen Paste, als auch in der bleifreien Paste in Form von Nanopartikeln vorliegen.

Die bleihaltige Paste wird vorzugsweise mit einer Schichtdicke aufgebracht, die nicht mehr als das 10-fache, bevorzugt nicht mehr als das 3-fache des mittleren Durchmessers der Metall-Partikel beträgt. Besonders bevorzugt wird die bleihaltige Paste mit einer Schichtdicke von 0,05 µm bis 10 µm besonders bevorzugt von 0,1 µm bis 5 µm aufgebracht.

Die Bleikonzentration von 1 bis 20 Gew. -% in Verbindung mit einer Dicke der aufgetragenen bleihaltigen Paste von 0,05 µm bis 10 µm und einer Breite von 20 µm bis 130 µm, bevorzugt 50 µm bis 100 µm, stellt ausreichende chemische Prozesse auf der Solarzellenoberfläche zur Herstellung eines guten elektrischen Kontakts sicher und gestattet andererseits den gesamten Bleigehalt in den Leiterbahnen in dem Rahmen von höchstens 0,1 Gewichts-% zu halten.

Bevorzugt wird die bleifreie Leiterschicht mit einer Schichtdicke von 10 µm bis 50 µm und besonders von 20 µm bis 35 µm aufgebracht.

Der Grenzwert von höchstens 0,1 Gewichts-% Blei in Summe über alle Leiterbahnen des Frontgitters, also in Summe über alle Gridfinger und Busbars, kann auch dadurch eingehalten werden, dass beispielsweise in den Busbars gar keine oder eine verhältnismäßig kleinere bleihaltige Kontaktschicht vorgesehen ist als in den Gridfingern. Während die Kontaktschicht auch in den Busbars die vorgenannten Abmessungen aufweist, wird die bleifreie Paste bzw. die Leiterschicht der Busbars vorzugsweise mit eine Breite von 1 mm - 3 mm aufgebracht.

In einer vorteilhaften Ausgestaltung wird die bleihaltige Paste auf unzusammenhängenden Teilflächen aufgebracht.

Es ist demnach erfindungsgemäß nicht erforderlich, die bleihaltige Kontaktschicht zusammenhängend auszubilden. Es genügen bereits diskrete Punkte oder Bereiche der Kontaktschicht, um den erzeugten Strom auf der Emitterseite zu sammeln. Diese Punkte oder Bereiche werden durch die mit der Kontaktschicht zumindest teilweise überlappende Leiterschicht elektrisch verbunden, so dass der Strom abgeleitet werden kann. Entsprechend genügt es, die bleihaltige Kontaktpaste beispielsweise in diskreten Punkten oder Bereichen auf die Emitterseite der Zelle und die bleifreie Paste derart darüber aufzubringen, dass die bedruckten oder beschriebenen Flächen der bleihaltigen Kontaktschicht und der bleifreien Leiterschicht zumindest teilweise überlappen. Durch die Reduzierung der Ausdehnung der von der bleihaltigen Paste abgedeckten Solarzellenoberfläche auf diskrete Punkte oder Bereiche kann die eingesetzte Bleimenge und somit der Blei-Anteil in der Leiterbahn weiter gesenkt werden.

Eine weitere vorteilhafte Maßnahme zur Verringerung des Blei-Anteils in der Leiterbahn ist, die bleihaltige Paste in Form eines schmalen Streifens oder schmaler Teilflächen aufzubringen, über der die bleifreie Leiterschicht mit vollständiger Bedeckung, vorzugsweise in Streifenform, aufgebracht wird. Unter vollständiger Bedeckung ist zu verstehen, dass die Schicht der bleihaltigen Paste nach allen lateralen Seiten und nach oben von der Schicht der bleifreien Paste bzw. Leiterschicht umgeben ist.

In einer vorteilhaften Weiterbildung des erfindungsgemäßen Verfahrens werden unmittelbar auf der bleihaltigen Paste oder Kontaktschicht oder auf der bleifreien Paste oder Leiterschicht in einem elektrischen Anschlussbereich der Busbars eine Bahn oder ein Punkt einer Zinn-Legierung aufgebracht.

Diese Maßnahme spart einerseits Silber ein. Andererseits eignet sich die Zinn-Legierung besonders gut als Kontaktmaterial zum Auflöten elektrischer Kontakte, also beispielsweise zum Anschließen der Verbinder.

Vorzugsweise werden mehrere Schichten der bleifreien Leiterschicht in aufeinanderfolgenden Schritten aufeinander aufgebracht und getrocknet. Hierdurch wird der Querschnitt des Gridfingers und/oder des gesamten Frontgitters erhöht.

Ein anderer Aspekt der vorliegenden Erfindung sieht eine Solarzelle mit einer einen Frontkontakt bildenden Leiterbahn, hergestellt nach dem Verfahren der vorstehend beschriebenen Art, vor, wobei der Bleigehalt in der Leiterbahn höchstens 0,1 Gew.-% bevorzugt unter 0,08 Gew.-% beträgt.

Die Solarzelle ist bevorzugt dergestalt ausgestattet, dass die Gridfinger elektrisch mit einem auf der Emitterseite angeordneten Busbar oder auf der Basisseite angeordneten Kontaktflächen verbunden ist. In ersterem Fall würde man von einer Standardzelle, in letzterem Fall entweder von einer MWA-(Metal-Wrap-Around) oder einer MWT-(Metal-Wrap-Through) Zelle sprechen.

Weitere Aspekte und Vorteile der Erfindung werden nachfolgend anhand von Ausführungsbeispielen im Zusammenhang mit den beiliegenden Figuren näher erläutert. Es zeigen:
- Figur 1: eine schematische Schnittdarstellung durch die erfindungsgemäße Solarzelle im Bereich eines elektrischen Kontaktes auf der Emitterseite;
- Figur 2: eine schematische Aufsichtsdarstellung auf die erfindungsgemäße Solarzelle im Bereich eines elektrischen Kontaktes auf der Emitterseite und
- Figur 3: ein Diagramm des Bleigehalts in der Leiterbahn in Abhängigkeit von der Dicke der aufgetragenen Schicht einer bleihaltigen Paste bei vorgegebener Schichtgeometrie.

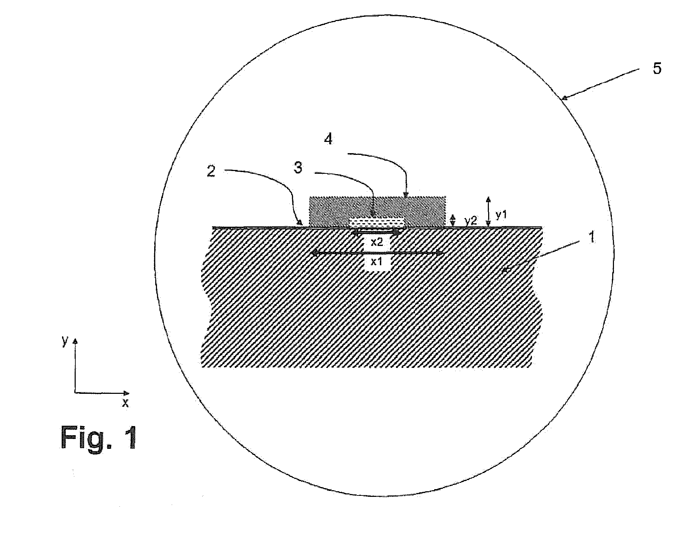

Der in Figur 1 dargestellte Solarzellenverbund 5 weist ein Halbleitersubstrat, vorzugsweise einen Silicium-Wafer 1, im Folgenden auch vereinfachend als Solarzelle bezeichnet, auf. Die Solarzelle ist auf der emitterseitigen Oberfläche mit einer Antireflexschicht 2 versehen. Unmittelbar auf der Antireflexschicht 2 ist zunächst eine bleihaltige elektrisch leitende Paste 3 in einem vorbestimmten Muster aufgebracht. Im vorliegenden Fall ist ein Querschnitt durch einen Streifen dieser Paste 3 dargestellt. Die Breite des Streifens wird als x2 und die Höhe als y2 markiert. Die Breite x2 beträgt beispielsweise für den Gridfinger vorzugsweise 20 µm bis 130 µm und besonders bevorzugt 50 µm bis 100 µm, deren Dicke y2 vorzugsweise 0,05 µm bis 10 µm und besonders bevorzugt 0,1 µm bis 5 µm.

Über die bleihaltige Paste 3 ist ein gleich breiter oder breiterer und jedenfalls dickerer Streifen einer elektrisch leitenden bleifreien Paste 4 mit vollständiger Bedeckung der darunterliegenden bleihaltigen Paste 3 aufgebracht. Die Breite des Streifens ist mit x1, die Dicke mit y1 bezeichnet. Die Breite x1 beträgt beispielsweise für den Gridfinger vorzugsweise 20 µm bis 130 µm und besonders bevorzugt 50 µm bis 100 µm, die Dicke y1 vorzugsweise 10 µm bis 50 µm und besonders bevorzugt 25 µm bis 35 µm. Dabei wird die Bleikonzentration unter der Annahme gleich langer Streifen 3 und 4 um einen Faktor (x1 * y1) / (x2 * y2) verdünnt.

Zunächst wird in dieser Gestalt die bleihaltige Paste- vorzugsweise mittels Siebdruck, Tintenstrahldruck oder Dispenserverfahren aufgebracht und getrocknet bzw. vorgetrocknet. Darüber wird die bleifreie Paste mit der gezeigten Geometrie bevorzugt ebenfalls mittels Siebdruck, Tintenstrahldruck oder Dispenserverfahren oder alternativ die Leiterschicht direkt galvanisch auf der Kontaktschicht abgeschieden. Die exakten geometrischen Abmessungen von Kontaktschicht und Leiterschicht werden unter Berücksichtigung des bekannten Pb- und Cd-Gehaltes vorzugsweise so berechnet, dass nach dem Sintern bzw. nach galvanischer Abscheidung der Leiterschicht die Bedingung Pb < 0,1 Gew.-% und Cd < 0,01 Gew.-% in Summe über alle Leiterbahnen des Frontgitters, also in Summe über alle Gridfinger und Busbars, eingehalten werden. Zu einer Einhaltung dieser Grenzwerte kann beispielsweise auch beitragen, dass in den Busbars gar keine oder eine verhältnismäßig kleinere Kontaktschicht vorgesehen ist als in den Gridfingern.

Der Streifen 3 der bleihaltigen Paste stellt aufgrund seines Bleioxidanteils beim Sintern durch chemische Reaktionen in der eingangs beschriebenen Weise den Kontakt zu der Silicium-Oberfläche der Solarzelle 1 her.

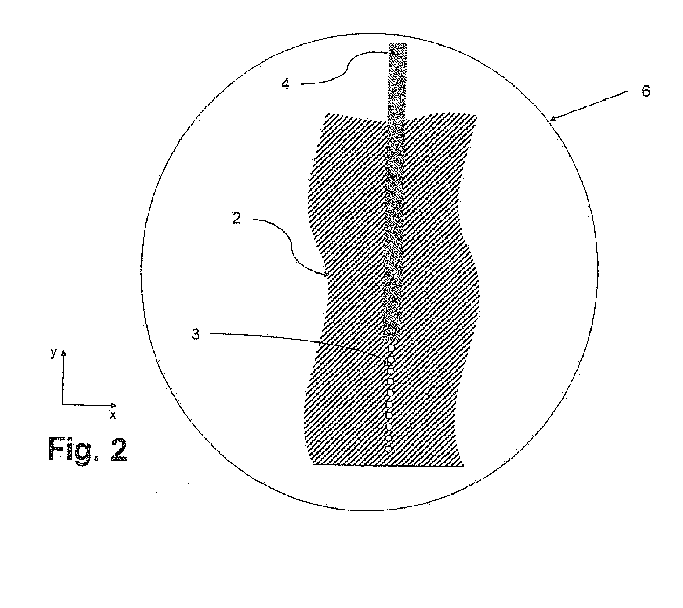

Um eine noch geringere Blei-Konzentration über die gesamte Leiterbahn zu erzielen, kann anstelle eines Streifens der bleihaltigen Paste 3 diese auch in Form unzusammenhängender Teilflächen, also beispielsweise einzelner Punkte, aufgetragen werden, wie in Figur 2 schematisch dargestellt. Hier ist ein Ausschnitt 6 des Substrats 1 mit Antireflexschicht 2 in der Aufsicht gezeigt. Das darauf abgelegte Muster der bleihaltigen Paste 3 weist eine Reihe diskrete Punkte auf, d.h. Punkte die einander nicht berühren, so dass zwischen diesen auch kein elektrischer Kontakt besteht. Die bleifreie Paste 4 ist darüber in Form eines kontinuierlichen Streifens aufgebracht, der die diskreten Punkte der bleihaltigen Paste überdeckt und somit elektrisch verbindet:, Dadurch verändert sich das Volumen- und damit Gewichtsverhältnis zwischen dem bleihaltigen und dem bleifreien Anteil der Leiterbahn nochmals zugunsten des bleifreien Anteils. Das Verhältnis kann mit (A1*y1)/(A2*y2) angegeben werden, wenn A1 die von der bleifreien Paste und A2 die von der bleihaltigen Paste benetzte Oberfläche angibt.

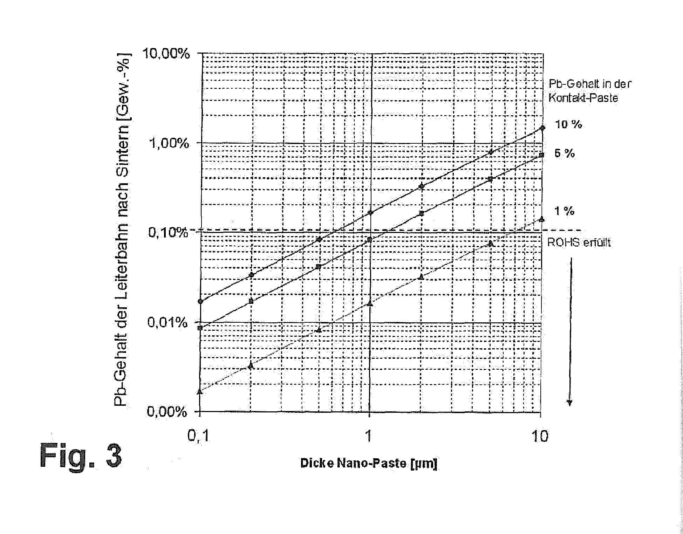

In Figur 3 ist der Bleigehalt in Gew. -% in der Leiterbahn nach dem Sintern in Abhängigkeit von der Dicke der bleihaltigen Paste bei konstanter Dicke der bleifreien Paste gezeigt. Dabei wird von bleihaltigen Pasten mit 3 unterschiedlichen Bleigehalten von 1,0 Gew. -% (Dreiecke) über 5,0 Gew. -% (Quadrate) bis 10 Gew. -% (Rauten) variiert. Es zeigt sich, dass der erfindungsgemäß angestrebte Bleigehalt in der gesinterten Leiterbahn von höchstens 0,1 Gew. -% für jede der Ausgangspasten eingehalten werden kann, wenn die Dicke, in der die bleihaltige Paste aufgetragen wird, proportional zu den steigenden Bleigehalt darin reduziert wird. So ist beispielsweise aus dem Diagramm abzulesen, dass im Fall eine Paste mit einem Bleigehalt von 10 Gew.-% die Schichtdicke der bleihaltigen Paste nicht mehr als 0,6 µm, im Fall einer Paste mit 5 Gew. -% Blei nicht mehr als 1,2 µm und im Fall einer Paste mit einem Gehalt von 1 Gew. -% Blei die Dicke der bleihaltigen Paste nicht mehr als 6 µm betragen darf.

Das Diagramm der Figur 3 ist insofern nur als exemplarisch zu sehen, als dies für feste laterale Geometrien beider Pasten sowie eine feste Schichtdicke y1 der bleifreien Paste gilt. Der Beibehalt kann ferner durch Variation der lateralen Geometrie sowie der Dicke der bleifreien Paste angepasst werden.

### Bezugszeichenliste

| | |
|---|---|
| 1 | Silicium-Wafer |
| 2 | Antireflexschicht |
| 3 | bleihaltige elektrisch leitende Paste/Kontaktschicht |
| 4 | bleifreie elektrisch leitende Paste/Leiterschicht |
| 5 | Solarzellenverbund |
| 6 | Ausschnitt |
| x1 | Breite des Streifens der bleifreie elektrisch leitende Paste/Leiterschicht |
| x2 | Breite des Streifens der bleihaltigen elektrisch leitende Paste/Kontaktschicht |
| y1 | Dicke des Streifens der bleifreie elektrisch leitende Paste/Leiterschicht |
| y2 | Dicke des Streifens der bleihaltigen elektrisch leitende Paste/Kontaktschicht |

## Patentansprüche

1. Verfahren zum Herstellen eines elektrischen Kontaktes auf der Emitterseite einer Solarzelle mit folgenden Schritten,
A) Aufbringen einer Schicht einer elektrisch leitenden bleihaltigen Paste (3) auf zumindest einem Oberflächenbereich der Solarzellenoberfläche,
B) Aufbringen einer elektrisch leitenden bleifreien Leiterschicht (4), gegebenenfalls in Form einer bleifreien Paste (4), über die Schicht der bleihaltigen Paste (3), so dass sich die Schichten (3, 4) zumindest teilweise überlappen,
C) Durchführung einer Wärmebehandlung, wobei die Pasten (3, 4) unter Ausbildung von einer eine Kontaktschicht (3) und eine Leiterschicht (4) enthaltenden Leiterbahn auf der Emitterseite gesintert werden,
wobei Schritt C) vor oder nach Schritt B) oder sowohl vor als auch nach Schritt B) durchgeführt werden kann und insbesondere bei Verwendung einer bleifreien Paste (4) nach Schritt B) durchgeführt wird.

2. Verfahren nach Anspruch 1,
**dadurch gekennzeichnet, dass**
die bleihaltige Paste (3) nach Schritt A) und vor Schritt B) getrocknet wird und/oder, dass die gegebenenfalls verwendete bleifreie Paste (4) nach Schritt B) und vor Schritt C) getrocknet wird.

3. Verfahren nach einem der vorstehenden Ansprüche,
**dadurch gekennzeichnet, dass**
Schritt C) vor Schritt B) durchgeführt wird, und in Schritt C) keine bleifreie Paste (4) sondern eine elektrisch leitende bleifreie Leiterschicht (4) durch galvanische Abscheidung aufgebracht wird.

4. Verfahren nach einem der vorstehenden Ansprüche,
**dadurch gekennzeichnet, dass**
das Verhältnis der aufgetragenen bleihaltigen Paste (3) zu der bleifreien Leiterschicht (4) unter Berücksichtigung des Bleigehalts in der bleihaltigen Paste (3) so gewählt ist, dass der Bleigehalt in der Leiterbahn (4) höchstens 0,1 Gew.-%, bevorzugt unter 0,08 Gew.-% beträgt.

5. Verfahren nach einem der vorstehenden Ansprüche,
**dadurch gekennzeichnet, dass**
die bleihaltige Paste (3) einen Bleigehalt von 1 bis 20 Gew.-%, bevorzugt von 5 bis 10 Gew.-% aufweist.

6. Verfahren nach einem der vorstehenden Ansprüche,
**dadurch gekennzeichnet, dass**
die Pasten (3, 4) Metallbestandteile in Partikelform, bevorzugt in Form von Kupfer-oder Aluminum-und besonders bevorzugt in Form von Silber-Partikeln enthalten.

7. Verfahren nach Anspruch 6,
**dadurch gekennzeichnet, dass**
zumindest die bleihaltige Paste (3) Nanopartikel enthält.

8. Verfahren nach Anspruch 6 oder 7,
**dadurch gekennzeichnet, dass**
die bleihaltige Paste (3) mit einer Schichtdicke (y2) aufgebracht wird, die nicht mehr als das 10-fache, bevorzugt nicht mehr als das 3-fache des mittleren Durchmessers der Partikel beträgt und insbesondere mit einer Schichtdicke (y2) von 0,05 µm bis 10 µm, bevorzugt von 0,1 µm bis 5 µm, aufgebracht wird.

9. Verfahren nach einem der vorstehenden Ansprüche,
**dadurch gekennzeichnet, dass**
die bleifreie Leiterschicht (4) mit einer Schichtdicke (y1) von 10 µm bis 50 µm, bevorzugt von 20 µm bis 35 µm aufgebracht wird.

10. Verfahren nach einem der vorstehenden Ansprüche,
**dadurch gekennzeichnet, dass**
die bleifreie Leiterschicht (4) und die bleihaltige Paste (3) jeweils mit einer Breite (x1, x2) von 20 µm bis 130 µm, bevorzugt von 50 µm bis 100 µm aufgebracht werden.

11. Verfahren nach einem der vorstehenden Ansprüche,
**dadurch gekennzeichnet, dass**
die bleihaltige Paste (3) auf unzusammenhängenden Teilflächen aufgebracht wird, wobei die unzusammenhängenden Teilflächen der bleihaltigen Paste (3) insbesondere durch die bleifreie Leiterschicht (4) verbunden werden.

12. Verfahren nach einem der vorstehenden Ansprüche,
**dadurch gekennzeichnet, dass**
die bleifreie Leiterschicht (4) mit vollständiger Bedeckung über der bleihaltigen Paste (3) aufgebracht wird.

13. Verfahren nach einem der vorstehenden Ansprüche,
**dadurch gekennzeichnet, dass**
unmittelbar auf der bleihaltigen Paste (3) oder auf der bleifreien Leiterschicht (4) in einem elektrischen Anschlussbereich eine Bahn oder ein Punkt einer Zinn-Legierung aufgebracht wird.

14. Solarzelle mit einen Frontkontakt bildenden Leiterbahnen, hergestellt nach dem Verfahren nach einem der vorstehenden Ansprüche,
**dadurch gekennzeichnet, dass**
der Bleigehalt in der Leiterbahn höchstens 0,1 Gew.-%, bevorzugt unter 0,08 Gew.-% beträgt.

15. Solarzelle nach Anspruch 14, **dadurch gekennzeichnet, dass** die Leiterbahnen Gridfinger aufweisen, die elektrisch mit einem auf der Emitterseite angeordneten Busbar (Standardzelle) oder auf der Basisseite angeordneten Busbar (MWA-oder MWT-Zelle) verbunden sind.
